(19) Europäisches Patentamt / European Patent Office / Office européen des brevets

(11) **EP 3 871 265 B1**

(12) **EUROPEAN PATENT SPECIFICATION**

(45) Date of publication and mention of the grant of the patent:
**11.06.2025 Bulletin 2025/24**

(21) Application number: **19817474.0**

(22) Date of filing: **13.11.2019**

(51) International Patent Classification (IPC):
*H10D 30/60* (2025.01)   *H10D 62/17* (2025.01)
*H10D 62/815* (2025.01)

(52) Cooperative Patent Classification (CPC):
**H10D 62/8162; H10D 30/60; H10D 62/371**

(86) International application number:
**PCT/US2019/061092**

(87) International publication number:
**WO 2020/102284 (22.05.2020 Gazette 2020/21)**

(54) **SEMICONDUCTOR DEVICE AND METHOD INCLUDING BODY CONTACT DOPANT DIFFUSION BLOCKING SUPERLATTICE HAVING REDUCED CONTACT RESISTANCE**

HALBLEITERBAUELEMENT UND -VERFAHREN EINSCHLIESSLICH SUPERGITTERN ZUR BLOCKIERUNG DER DOTIERSTOFFDIFFUSION MIT REDUZIERTEM KONTAKTWIDERSTAND

DISPOSITIF À SEMI-CONDUCTEUR ET PROCÉDÉ COMPRENANT UN SUPER-RÉSEAU DE BLOCAGE DE DIFFUSION DE DOPANT DE CONTACT DE CORPS PRÉSENTANT UNE RÉSISTANCE DE CONTACT RÉDUITE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.11.2018 US 201816193011**
**16.11.2018 US 201816193000**

(43) Date of publication of application:
**01.09.2021 Bulletin 2021/35**

(73) Proprietor: **Atomera Incorporated**
**Los Gatos, CA 95032 (US)**

(72) Inventors:
• **TAKEUCHI, Hideki**
**San Jose, CA 95129 (US)**
• **CONNELLY, Daniel**
**San Francisco, CA 94110 (US)**
• **HYTHA, Marek**
**Brookline, MA 02446 (US)**
• **BURTON, Richard**
**Phoenix, AZ 85048 (US)**
• **MEARS, Robert J.**
**Wellesley, MA 02482 (US)**

(74) Representative: **Page White Farrer**
**Bedford House**
**21a John Street**
**London WC1N 2BF (GB)**

(56) References cited:
**US-A1- 2005 279 991    US-A1- 2011 227 191**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## Technical Field

The present disclosure generally relates to semiconductor devices and, more particularly, to semiconductor devices with enhanced contact configurations and related methods.

## Background

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472,685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fractional or binary or a binary compound semiconductor layer, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of SiO2/Si with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electroluminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

U.S. Pat. No. 7,105,895 to Wang et al. discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc., can be tailored to yield new aperiodic materials with desirable band-structure characteristics. Other parameters, such as electrical conductivity, thermal conductivity and dielectric permittivity or magnetic permeability are disclosed as also possible to be designed into the material.

Furthermore, U.S. Pat. No. 6,376,337 to Wang et al. discloses a method for producing an insulating or barrier layer for semiconductor devices which includes depositing a layer of silicon and at least one additional element on the silicon substrate whereby the deposited layer is substantially free of defects such that epitaxial silicon substantially free of defects can be deposited on the deposited layer. Alternatively, a monolayer of one or more elements, preferably comprising oxygen, is absorbed on a silicon substrate. A plurality of insulating layers sandwiched between epitaxial silicon forms a barrier composite.

US 2005/0279991A1 discloses a semiconductor device which includes a superlattice that, in turn, includes a plurality of stacked groups of layers. Each group of the superlattice may include a plurality of stacked base semiconductor monolayers defining a base semiconductor portion and an energy band-modifying layer thereon.

US 2011/0227191A1 discloses a silicon-on-insulator device with a buried depletion shield layer.

Despite the existence of such approaches, further enhancements may be desirable for using advanced semiconductor materials and processing techniques to achieve improved performance in semiconductor devices.

## Summary

A semiconductor device according to the invention includes a semiconductor layer, spaced apart source and drain regions in the semiconductor layer with a channel region extending therebetween, and a gate on the channel region. The semiconductor device includes a body contact in the semiconductor layer and comprising a body contact dopant diffusion blocking superlattice within the semiconductor layer and extending through the body contact to divide the body contact into a first body contact region and a second body contact region, with the second body contact region having a same conductivity and higher dopant concentration than the first body contact region. The semiconductor device further includes a metal contact on the second body contact region. The body contact dopant diffusion blocking superlattice includes a respective plurality of stacked groups of layers, with each group of layers comprising a plurality of stacked base semiconductor monolayers defining a base semiconductor portion, and at least one non-semiconductor monolayer constrained within a crystal lattice of adjacent base semiconductor portions.

In one example embodiment, the source and drain regions and the body contact may be on a top side of the semiconductor layer. In accordance with another example embodiment, the source and drain regions may be on the top side of the semiconductor layer, and the body contact may be on a back side of the semiconductor layer opposite the top side.

The second body contact region may be level with a second surface of the semiconductor layer in one example embodiment. In accordance with another example, the second body contact region may be raised above a second surface of the semiconductor layer. Furthermore, the first body contact region may comprise a different material than the second body contact region. For example, the first body contact region may comprise silicon, and the second body contact region may comprise silicon germanium. In accordance with another example, the first body contact region may comprise silicon germanium, and the second body contact region may comprise silicon.

By way of example, the metal contact may comprise at least one of titanium, cobalt, nickel and platinum. Also by way of example, the base semiconductor monolayers may comprise silicon, and the at least one non-semiconductor monolayer may comprise oxygen.

A method for making a semiconductor device according to the invention includes forming spaced apart source and drain regions in a semiconductor layer with a channel region extending therebetween, and forming a gate on the channel region. The method further includes forming a body contact in the semiconductor layer and including a body contact dopant diffusion blocking superlattice within the semiconductor layer and extending through the body contact to divide the body contact into a first body contact region and a second body contact region, with the second body contact region having a same conductivity and higher dopant concentration than the first body contact region. The method further includes forming a metal contact on the second body contact region. The body contact dopant diffusion blocking superlattice includes a respective plurality of stacked groups of layers, with each group of layers including a plurality of stacked base semiconductor monolayers defining a base semiconductor portion, and at least one non-semiconductor monolayer constrained within a crystal lattice of adjacent base semiconductor portions.

In one example embodiment, the source and drain regions and the body contact may be on a top side of the semiconductor layer. In accordance with another example embodiment, the source and drain regions may be on the top side of the semiconductor layer, and the body contact may be on a back side of the semiconductor layer opposite the top side.

## Brief Description of the Drawings

FIG. 1 is a greatly enlarged schematic cross-sectional view of a superlattice for use in a semiconductor device in accordance with an example embodiment.

FIG. 2 is a perspective schematic atomic diagram of a portion of the superlattice shown in FIG. 1.

FIG. 3 is a greatly enlarged schematic cross-sectional view of another embodiment of a superlattice in accordance with an example embodiment.

FIG. 4A is a graph of the calculated band structure from the gamma point (G) for both bulk silicon as in the prior art, and for the 4/1 Si/O superlattice as shown in FIGS. 1-2.

FIG. 4B is a graph of the calculated band structure from the Z point for both bulk silicon as in the prior art, and for the 4/1 Si/O superlattice as shown in FIGS. 1-2.

FIG. 4C is a graph of the calculated band structure from both the gamma and Z points for both bulk silicon as in the prior art, and for the 5/1/3/1 Si/O superlattice as shown in FIG. 3.

FIG. 5 is a schematic cross-sectional diagram of a semiconductor device including a dopant diffusion blocking superlattice dividing the source and drain regions to provide reduced source and drain contact resistance.

FIG. 6 is a schematic cross-sectional diagram of a semiconductor device including source and drain regions divided by respective dopant diffusion blocking superlattices and providing reduced source and drain contact resistance.

FIGS. 7A-7C are a series of schematic cross-sectional diagrams illustrating a method of making a semiconductor device with interim source and drain superlattice layers to provide Schottky barrier height modulation by controlling interfacial insulator formation.

FIGS. 8-9 are a schematic cross-sectional diagrams of example semiconductor devices including source and drain regions divided by respective superlattices and having a different upper and lower semiconductor source/drain materials and metal contact regions.

FIG. 10 is a perspective view of a FINFET including source and drain regions divided by respective superlattices and providing reduced source and drain contact resistance.

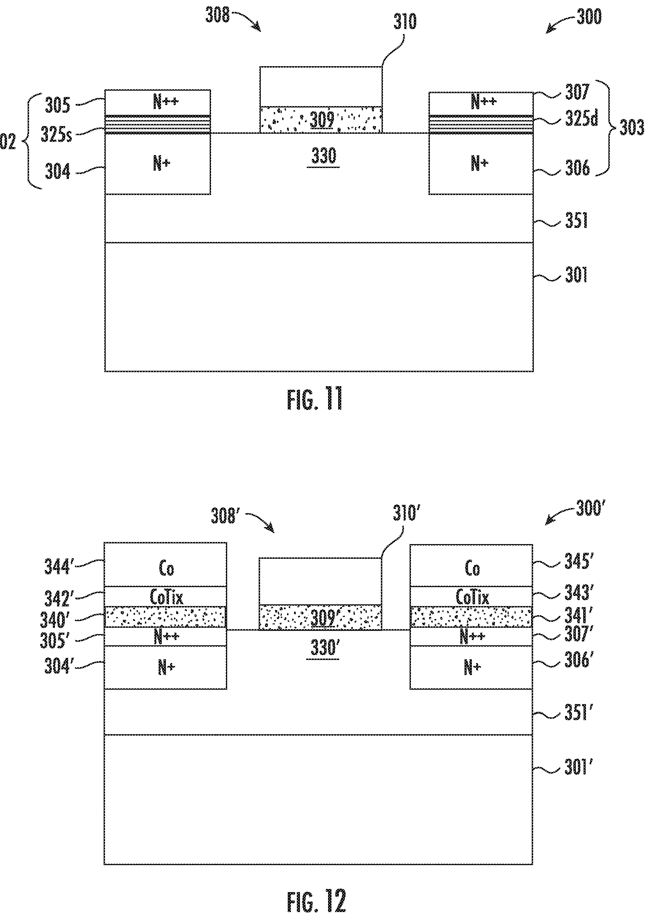

FIG. 11 is a cross-sectional view of the FINFET of FIG. 10 taken along line A-A.

FIG. 12 is a cross-sectional view of an alternative embodiment of the FINFET of FIG. 10 taken along line A-A formed using a similar process to that shown in FIGS. 7A-7C.

FIGS. 13 and 14 are cross-sectional views of alternative embodiments of the FINFET of FIG. 10 taken along line A-A which includes similar source and drain configurations to the devices of FIGS. 8 and 9, respectively.

FIG. 15 is a series of schematic atomic level diagrams illustrating approaches by which non-semiconductor insertion layers from the MST films shown in FIGS. 1-4C may be used to provide the metal-semiconductor contacts with proximate dopants for reduced Schottky barrier heights in the embodiments of FIGS. 5-14.

FIG. 16 is a schematic cross-sectional diagram of a semiconductor device including a body contact with a dopant diffusion blocking superlattice to provide reduced contact resistance in accordance with an example embodiment.

FIG. 17 is a schematic cross-sectional diagram of a semiconductor device including a back side body contact with a dopant diffusion blocking superlattice to provide reduced contact resistance in accordance with an example embodiment.

FIG. 18 is a cross sectional view of an alternative contact structure which may be used to provide reduced contact resistance in accordance with an example embodiment.

## Detailed Description

Example embodiments will now be described more fully hereinafter with reference to the accompanying drawings, in which the example embodiments are shown. The embodiments may, however, be implemented in many different forms and should not be construed as limited to the specific examples set forth herein. Rather, these embodiments are provided so that this disclosure will be thorough and complete. Like numbers refer to like elements throughout, and prime and multiple prime notation are used to indicate similar elements in different embodiments.

Generally speaking, the present disclosure relates to utilizing enhanced superlattice materials within source and drain regions to reduce Schottky barrier height and thereby decrease source and drain contact resistance. The enhanced semiconductor superlattice is also referred to as an "MST" layer or "MST technology" in this disclosure and the accompanying drawings.

More particularly, the MST technology relates to advanced semiconductor materials such as the superlattice **25** described further below. Applicant theorizes, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicants use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum_{E>E_F} \int_{B.Z.} \left(\nabla_{\mathbf{k}} E(\mathbf{k},n)\right)_i \left(\nabla_{\mathbf{k}} E(\mathbf{k},n)\right)_j \frac{\partial f(E(\mathbf{k},n),E_F,T)}{\partial E} d^3\mathbf{k}}{\sum_{E>E_F} \int_{B.Z.} f(E(\mathbf{k},n),E_F,T) d^3\mathbf{k}}$$

for electrons and:

$$\mathbf{M}_{h,ij}^{-1}(E_F,T) = \frac{-\sum_{E<E_F} \int_{B.Z.} \left(\nabla_{\mathbf{k}} E(\mathbf{k},n)\right)_i \left(\nabla_{\mathbf{k}} E(\mathbf{k},n)\right)_j \frac{\partial f(E(\mathbf{k},n),E_F,T)}{\partial E} d^3\mathbf{k}}{\sum_{E<E_F} \int_{B.Z.} (1-f(E(\mathbf{k},n),E_F,T)) d^3\mathbf{k}}$$

for holes, where $f$ is the Fermi-Dirac distribution, $E_F$ is the Fermi energy, T is the temperature, E($\mathbf{k}$,n) is the energy of an electron in the state corresponding to wave vector $\mathbf{k}$ and the $n^{th}$ energy band, the indices i and j refer to Cartesian coordinates x, y and z, the integrals are taken over the Brillouin zone (B.Z.), and the summations are taken over bands with energies above and below the Fermi energy for electrons and holes respectively.

Applicant's definition of the conductivity reciprocal effective mass tensor is such that a tensorial component of the conductivity of the material is greater for greater values of the corresponding component of the conductivity reciprocal effective mass tensor. Again Applicant theorizes without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for electrons/holes as described above and calculated in the direction of intended carrier transport is used to distinguish improved materials.

Applicant has identified improved materials or structures for use in semiconductor devices. More specifically, Applicant has identified materials or structures having energy band structures for which the appropriate conductivity effective masses for electrons and/or holes are substantially less than the corresponding values for silicon. In addition to the enhanced mobility characteristics of these structures, they may also be formed or used in such a manner that they provide piezoelectric, pyroelectric, and/or ferroelectric properties that are advantageous for use in a variety of different types of devices, as will be discussed further below.

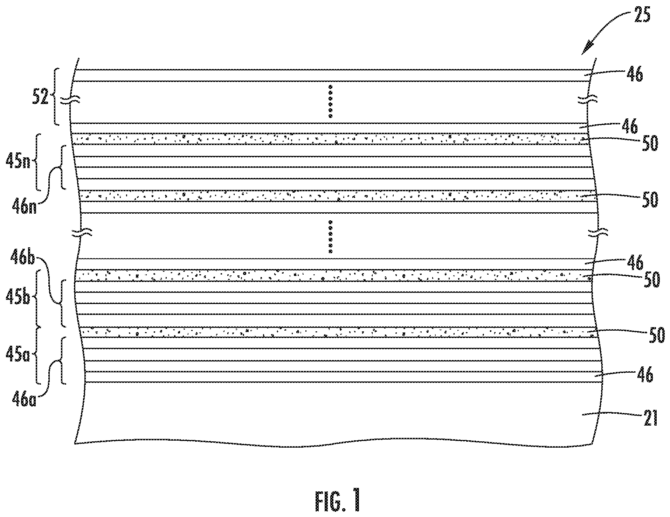

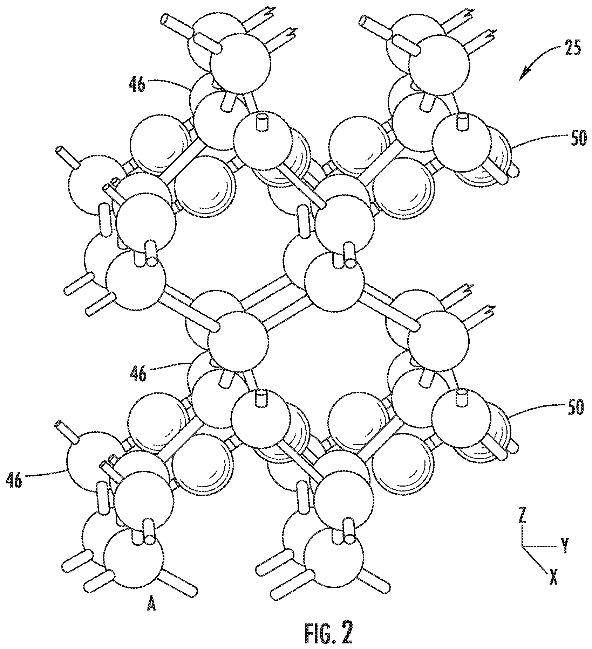

Referring now to FIGS. 1 and 2, the materials or structures are in the form of a superlattice **25** whose structure is controlled at the atomic or molecular level and may be formed using known techniques of atomic or molecular layer deposition. The superlattice **25** includes a plurality of layer groups **45a-45n** arranged in stacked relation, as perhaps best understood with specific reference to the schematic cross-sectional view of FIG. 1.

Each group of layers **45a-45n** of the superlattice **25** illustratively includes a plurality of stacked base semiconductor monolayers **46** defining a respective base semiconductor portion **46a-46n** and an energy band-modifying layer **50** thereon. The energy band-modifying layers **50** are indicated by stippling in FIG. 1 for clarity of illustration.

The energy band-modifying layer **50** illustratively includes one non-semiconductor monolayer constrained within a crystal lattice of adjacent base semiconductor portions. By "constrained within a crystal lattice of adjacent base semiconductor portions" it is meant that at least some semiconductor atoms from opposing base semiconductor portions **46a-46n** are chemically bound together through the non-semiconductor monolayer **50** therebetween, as seen in FIG. 2. Generally speaking, this configuration is made possible by controlling the amount of non-semiconductor material that is deposited on semiconductor portions **46a-46n** through atomic layer deposition techniques so that not all (i.e., less than full or 100% coverage) of the available semiconductor bonding sites are populated with bonds to non-semiconductor atoms, as will be discussed further below. Thus, as further monolayers **46** of semiconductor material are deposited on or over a non-semiconductor monolayer **50,** the newly deposited semiconductor atoms will populate the remaining vacant bonding sites of the semiconductor atoms below the non-semiconductor monolayer.

In other embodiments, more than one such non-semiconductor monolayer may be possible. It should be noted that reference herein to a non-semiconductor or semiconductor monolayer means that the material used for the monolayer would be a non-semiconductor or semiconductor if formed in bulk. That is, a single monolayer of a material, such as silicon, may not necessarily exhibit the same properties that it would if formed in bulk or in a relatively thick layer, as will be appreciated by those skilled in the art.

Applicant theorizes without wishing to be bound thereto that energy band-modifying layers **50** and adjacent base semiconductor portions **46a-46n** cause the superlattice **25** to have a lower appropriate conductivity effective mass for the charge carriers in the parallel layer direction than would otherwise be present. Considered another way, this parallel direction is orthogonal to the stacking direction. The band modifying layers **50** may also cause the superlattice **25** to have a common energy band structure, while also advantageously functioning as an insulator between layers or regions vertically above and below the superlattice.

Moreover, this superlattice structure may also advantageously act as a barrier to dopant and/or material diffusion between layers vertically above and below the superlattice **25**. These properties may thus advantageously allow the superlattice **25** to provide an interface for high-K dielectrics which not only reduces diffusion of the high-K material into the channel region, but which may also advantageously reduce unwanted scattering effects and improve device mobility, as will be appreciated by those skilled in the art.

It is also theorized that semiconductor devices including the superlattice **25** may enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example.

The superlattice **25** also illustratively includes a cap layer **52** on an upper layer group **45n**. The cap layer **52** may comprise a plurality of base semiconductor monolayers **46**. The cap layer **52** may have between 2 to 100 monolayers of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, carbon and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art. More particularly, the base semiconductor may comprise at least one of silicon and germanium, for example

It should be noted that the term monolayer is meant to include a single atomic layer and also a single molecular layer. It is also noted that the energy band-modifying layer **50** provided by a single monolayer is also meant to include a monolayer wherein not all of the possible sites are occupied (i.e., there is less than full or 100% coverage). For example, with particular reference to the atomic diagram of FIG. 2, a 4/1 repeating structure is illustrated for silicon as the base semiconductor material, and oxygen as the energy band-modifying material. Only half of the possible sites for oxygen are occupied in the illustrated example.

In other embodiments and/or with different materials this one-half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice **25** in accordance with the invention may be readily adopted and implemented, as will be appreciated by those skilled in the art.

It is theorized without Applicant wishing to be bound thereto that for a superlattice, such as the Si/O superlattice, for example, that the number of silicon monolayers should desirably be seven or less so that the energy band of the superlattice is common or relatively uniform throughout to achieve the desired advantages. The 4/1 repeating structure shown in FIGS. 1 and 2, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons and holes, or just one of these types of charge carriers as will be appreciated by those skilled in the art.

The lower conductivity effective mass for the 4/1 Si/O embodiment of the superlattice **25** may be less than two-thirds the conductivity effective mass than would otherwise occur, and this applies for both electrons and holes. Of course, the superlattice **25** may further comprise at least one type of conductivity dopant therein, as will also be appreciated by those skilled in the art.

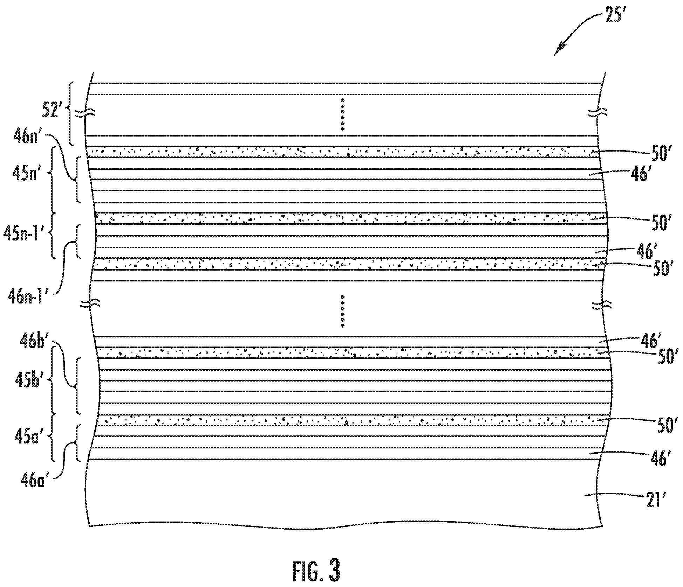

Indeed, referring now additionally to FIG. 3, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'**. The energy band-modifying layers **50'** may each include a single monolayer. For such a superlattice **25'** including Si/O, the enhancement of charge carrier mobility is independent of orientation in the plane of the layers. Those other elements of FIG. 3 not specifically mentioned are similar to those discussed above with reference to FIG. 1 and need no further discussion herein.

In some device embodiments, all of the base semiconductor portions of a superlattice may be a same number of monolayers thick. In other embodiments, at least some of the base semiconductor portions may be a different number of monolayers thick. In still other embodiments, all of the base semiconductor portions may be a different number of monolayers thick.

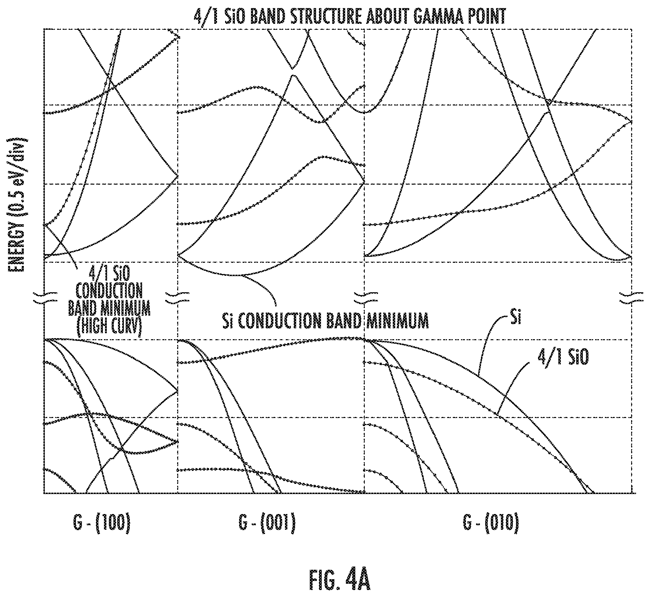

In FIGS. 4A-4C, band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 4A shows the calculated band structure from the gamma point (G) for both bulk silicon (represented by continuous lines) and for the 4/1 Si/O superlattice **25** shown in FIG. 1 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

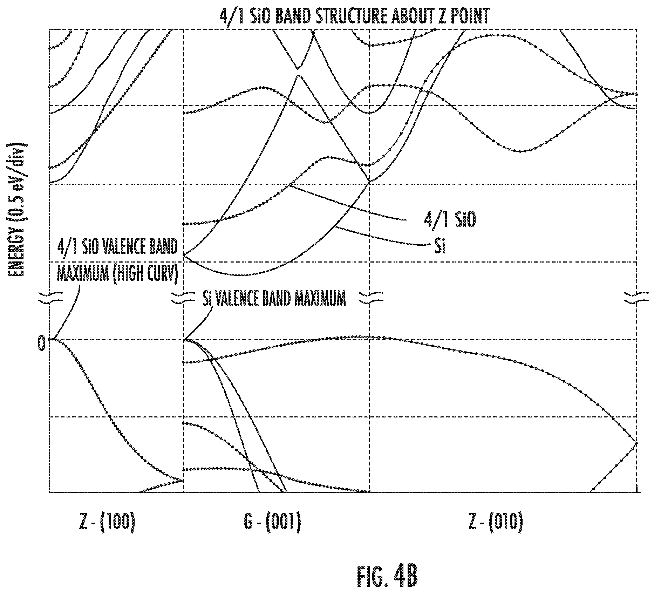

FIG. 4B shows the calculated band structure from the Z point for both bulk silicon (continuous lines) and for the 4/1 Si/O superlattice **25** (dotted lines). This figure illustrates the enhanced curvature of the valence band in the (100) direction.

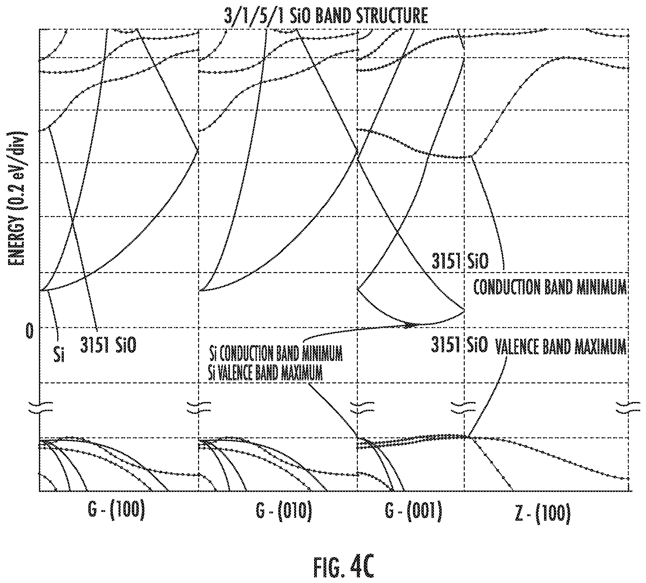

FIG. 4C shows the calculated band structure from both the gamma and Z point for both bulk silicon (continuous lines) and for the 5/1/3/1 Si/O structure of the superlattice **25'** of FIG. 3 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicant to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

Having now described the structure and formation of example MST materials, various embodiments of semiconductor devices and method for their manufacture will now be described which advantageously provide for metal-silicon contacts with proximate dopants using the above-described MST materials. By way of background, it is typical in semiconductor devices for electrons to be transferred between a semiconductor (such as silicon) and conducting metal "interconnects" which transfer charge between semiconductor devices. Electrical resistance between the semiconductor and metal increases the energy required and reduces the maximum speed of computations and other functions performed by circuits using the devices. It is thus advantageous to minimize this electrical resistance.

When electrons are transferred between a metal and a semiconductor such as silicon, there is a potential barrier encountered by the electron. This barrier is typically referred to as the "Schottky barrier." Electrons can either have sufficient kinetic energy to overcome the Schottky barrier directly, or electrons with lower kinetic energy may pass between the metal and semiconductor via quantum mechanical tunneling. Such tunneling is more likely the spatially thinner the Schottky barrier. A typical way to attain a reduced barrier is to increase the electric field. Higher levels of ionized impurities ("dopants") typically yield higher electric fields and thus increase the tunneling probability, increasing the electron flux between the metal and the semiconductor, thus reducing the effective electrical resistance. But in addition to increasing the electric field, high levels of impurities may additionally reduce the Schottky barrier itself, by reducing the effective band gap of the semiconductor immediately adjacent to the metal-semiconductor interface (and via other chemical effects). This effect is evident from density functional theory calculations.

Oxygen insertion (OI) layers (or other non-semiconductor layers), such as provided in an MST film, for example, may contribute to a lower Schottky and/or thinner barrier by trapping dopants. Density functional theory calculations have shown that OI layers provide for the favorable substitution of specific dopant atoms for silicon atoms within one or two atomic layers of the OI layer. By trapping dopants immediately proximate to, for example, separated by one or two atomic layers from, a metal-semiconductor interface, OI layers may thus contribute to a relatively higher concentration of dopants immediately adjacent to the metal-semiconductor interface, increasing the electric field, and additionally reducing the Schottky barrier.

In addition to trapping dopants, OI layers may immobilize them by trapping point defects that would otherwise aid the diffusion of dopants. So, while an OI layer proximate to a metal-semiconductor layer may trap dopants immediately adjacent to that interface, additional OI layers further from but still proximate to the interface may trap point defects that would otherwise aid in the diffusion of dopants away from the interface. Thus, it may be beneficial to have more than one, for example two, three, or four, OI layers proximate to the interface.

Generally speaking, the embodiments described herein utilize one or more oxygen insertion ("OI" or "MST") layers in close proximity to a metal-semiconductor interface in conjunction with a high (for example, in excess of $10^{21}/cm^3$, or 2% of crystalline sites in the silicon lattice) of ionized impurities such as boron, phosphorus, arsenic, antimony, indium, or gallium in the near proximity (for example, closer than 1 nm) to the metal-silicon interface. Examples of metals include aluminum, tungsten, nickel, titanium, copper, cobalt, indium, gold, platinum, erbium, ytterbium, and compounds of any of these metals with silicon or germanium.

Since the OI layers may provide for favorable substitution by dopant atoms of silicon atoms one or two atomic layers away, the most favorable separation of an OI layer from a metal-semiconductor interface is one or two atomic layers, allowing for the trapping of a high concentration of dopants up to and immediately adjacent to the metal-semiconductor interface. But benefits may also be provided with other separations, for example three, or four atomic layers. Additionally, there may be a benefit in including additional oxygen insertion layers in addition to this first oxygen insertion layer.

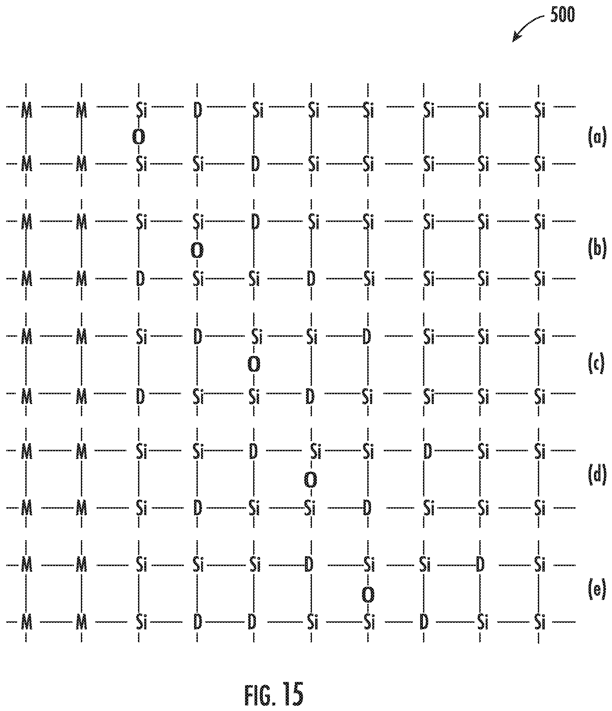

Examples of this approach are represented in the graph **500** of FIG. 15, in which: Si = Silicon atom; M = Metal atom (e.g. titanium); O = Oxygen atom; and D = Dopant atom (e.g. boron). The oxygen atoms as drawn are part of oxygen insertion layers, where the oxygen is bonded with adjacent silicon atoms. While oxygen atoms are necessarily present in the OI layers, there may also additionally be nitrogen atoms, which are not represented in the figure. The presence of nitrogen may be beneficial for the trapping of dopants or for the thermal stability of the OI layers, for example.

Similarly, the represented dopants are replacing silicon atoms in the crystalline lattice, as opposed to occupying "interstitial" positions or in dopant clusters where they will fail to contribute to free carriers in the semiconductor. However, while substitutional dopants are represented in the figure, a high concentration of dopants trapped near the metal-semiconductor interface may reduce a Schottky barrier with alternate atomic configurations. The positions of dopants in the diagram are a schematic representative for illustrational purposes. An actual distribution of dopant atoms will be in part random, influenced by the specific atomic configuration of oxygen atoms, and the local bonding of atoms. The illustrated configurations represent the distance of atoms from the metal-semiconductor interface, not specific positions of atoms within layers. The illustrated configurations are as follows:

(a) OI layer in contact with metal, trapping dopants below the OI layer;
(b) OI layer separated by one atomic layer of silicon from the metal, trapping dopants both above and below the OI layer;
(c) OI layer separated by two atomic layers from the metal, trapping dopants both above and below the OI layer;
(d) OI layer separated by three atomic layers from the metal, trapping dopants both above and below the OI layer, but in this example not reaching the metal interface itself;
(e) OI layer separated by four atomic layers from the metal, trapping dopants both above and below the OI layer, but in this example not reaching the metal interface itself.

In addition to these configurations, additional configurations with multiple OI layers are also possible, for example one layer separated from the metal-semiconductor interface by two silicon layers, and an additional layer separated by an additional four atomic layers. These multiple layers may provide for dopant trapping both at the metal-semiconductor interface, and additionally below the metal-semiconductor interface, the former contributing to chemical Schottky barrier lowering and a higher electric field, the latter contributing primarily through higher electric field. The embodiments set forth herein are generally defined by the presence of a layer proximate to the metal-semiconductor interface in conjunction with a high concentration of dopants, but does not exclude additional layers or dopant atoms not proximate to OI layer(s). A specific advantage of additional OI layers is these additional layers may increase the stability of the structure, for example blocking the loss of oxygen from the layer closest to the metal-semiconductor interface, or trapping point defects which otherwise would contribute to a loss of dopant atoms from the region proximate to the metal-semiconductor interface.

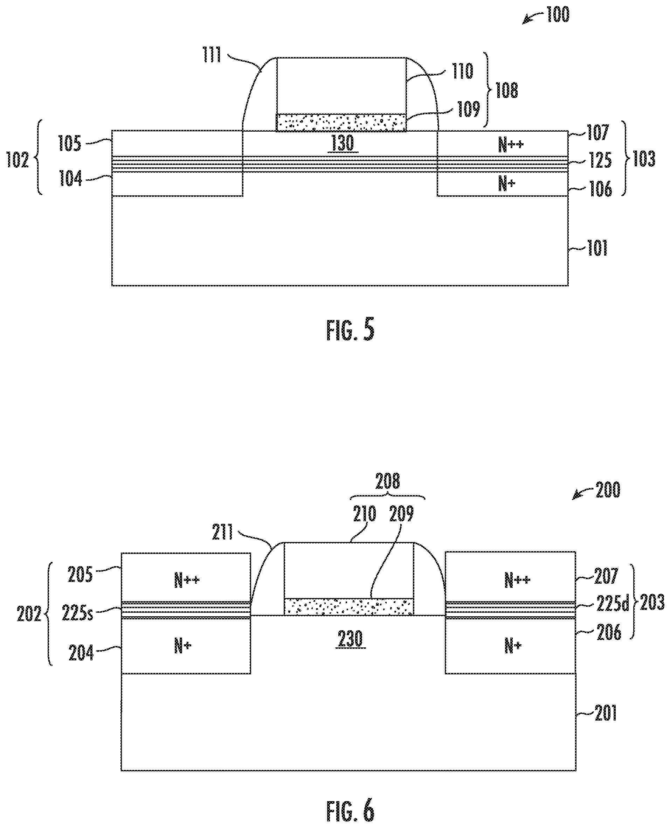

Referring now to FIG. 5, the above-described superlattice structures may advantageously be used in semiconductor devices to provide reduced source/drain contact resistance by applying the above-described principles. In typical semiconductor processes, the reduction of metal to semiconductor contact area requires lower contact resistivity (e.g., $\rho_c$<1E-8 ohm.cm$^2$). Contact resistivity is determined by two parameters, which are:

$N_D$:      active dopant concentration at metal/semiconductor interface; and
$\Phi F_{Bo}$:      Schottky barrier height at metal/semiconductor interface

Furthermore, the metal-semiconductor Schottky barrier height is "pinned" for different metals. Moreover, an interfacial insulator can "de-pin" the Fermi level depending on thickness, bandgap, and permittivity.

In the semiconductor device **100** shown in FIG. 5 (a FET), a dopant diffusion blocking superlattice **125** (such as those described above in FIGS. 1-4C) is used to advantageously increase surface dopant concentration to allow a higher $N_D$ during in-situ doped epitaxial processing by preventing diffusion into a channel region **130** of the device. More particularly, the device **100** illustratively includes a semiconductor layer or substrate **101,** and spaced apart source and drain regions **102, 103** formed in the semiconductor layer with the channel region **130** extending therebetween. The dopant diffusion blocking superlattice **125** illustratively extends through the source region **102** to divide the source region into a lower source region **104** and an upper source region **105,** and also extends through the drain region **103** to divide the drain region into a lower drain region **106** and an upper drain region **107.**

The dopant diffusion blocking superlattice **125** may also conceptually be considered as a source dopant blocking superlattice within the source region **102,** a drain dopant blocking superlattice within the drain region **103,** and a body dopant blocking superlattice beneath the channel **130,** although in this configuration all three of these are provided by a single blanket deposition of the MST material across the substrate **101** as a continuous film. The semiconductor material above the dopant blocking superlattice **125** in which the upper source/drain regions **105, 107** and channel region **130** are defined may be epitaxially grown on the dopant blocking superlattice **125** either as a thick superlattice cap layer or bulk semiconductor layer, as discussed further above. In the illustrated example, the upper source/drain regions **105, 107** may each be level with an upper surface of this semiconductor layer (i.e., they are implanted within this layer).

As such, the upper source/drain regions **105, 107** may advantageously have a same conductivity as the lower source/drain regions **104, 106,** yet with a higher dopant concentration. In the illustrated example, the upper source/drain regions **105, 107** and the lower source/drain regions **104, 106** are N-type for a N-channel device, but these regions may also be P-type for an P-channel device as well (this applies to other configurations described herein as well). Surface dopant may be introduced by ion implantation, for example. Yet, the dopant diffusion is reduced by the MST film material of the diffusion blocking superlattice **125** because it traps point defects/interstitials introduced by ion implantation which mediate dopant diffusion.

The semiconductor device **100** further illustratively includes a gate **108** on the channel region **130.** The gate illustratively includes a gate insulating layer **109** gate electrode **110.** Sidewall spacers **111** are also provided in the illustrated example.

Referring now to FIG. 6, in accordance with another example implementation a semiconductor device **200** (FET) illustratively includes a semiconductor layer or substrate **201,** and spaced apart source and drain regions **202, 203** with a channel region **230** extending therebetween. In the illustrated embodiment, a source diffusion blocking superlattice **225s** illustratively extends through the source region **202** to divide the source region into a lower source region **204** and an upper source region **205.** Similarly, a drain diffusion blocking superlattice **225d** extends through the drain region **203** to divide the drain region into a lower drain region **206** and an upper drain region **207.** Considered alternatively, the upper source and drain regions **205, 207** are each raised above an upper surface of the semiconductor layer **201,** and there is no superlattice extending between the source and drain regions **202, 203** as in the example of FIG. 5 (i.e., beneath gate **208**). The gate **208** illustratively includes a gate insulator **209** and gate electrode **210,** and gate sidewall spacers **211** may also be provided.

In this implementation, the surface dopant in the upper source/drain regions **205, 207** may be introduced by selectively growing MST films, followed by in-situ doped epi film formation. Here again, the MST material of the source/drain dopant diffusion blocking superlattices **225s, 225b** advantageously helps prevent dopant diffusion into the channel region **230,** and thus allows higher surface dopant concentration as noted above.

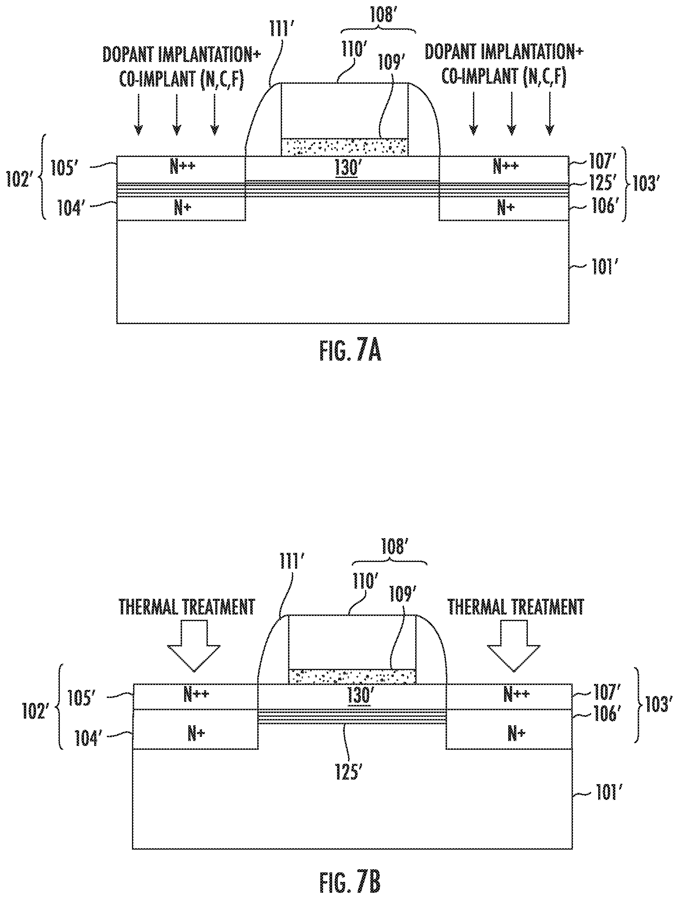

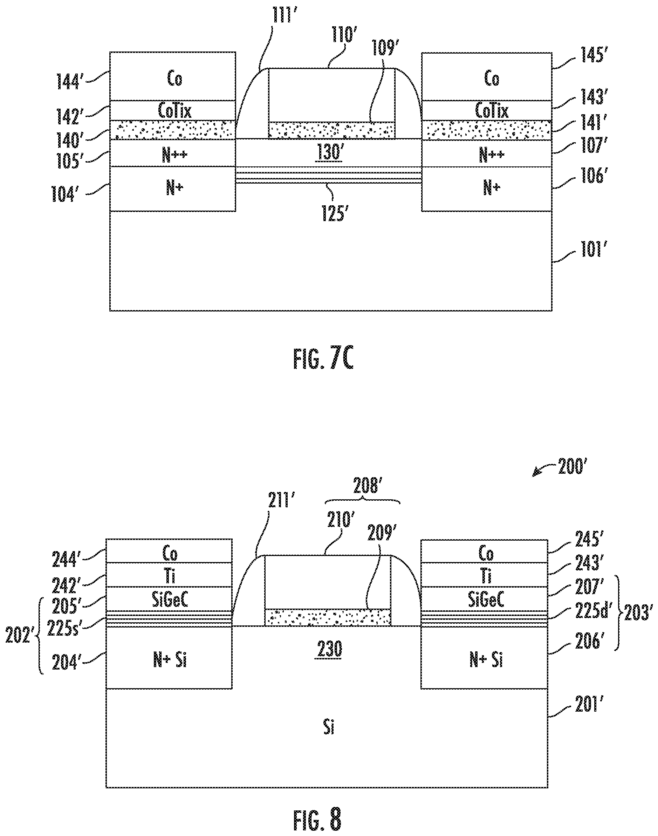

In accordance with another example implementation now described with reference to FIGS. 7A-7C, further processing steps may be performed to the semiconductor device **100** shown in FIG. 5 to perform Schottky barrier height modulation by controlling a thickness and composition of an interfacial insulator. With traditional metal contacts, too thick of a source/drain insulator results in high contact resistivity due to high tunneling resistance. However, the superlattice **125'** advantageously provides desired non-semiconductor (e.g., oxygen) dose control for Fermi-level de-pinning and tunneling resistance. After formation of the gate **108'** on the channel region **130',** co-implantation of N, C, or F may further modulate insulator composition for lower permittivity (e.g., C and F used for low-k ILD film to modulate $SiO_2$ composition), as illustrated in FIG. 7A. The MST film of the superlattice **125'** effectively accumulates these elements into the surface region.

It should be noted that in some embodiments N and C may be incorporated into silicon surface by gaseous form (e.g., $N_2$ anneal or CO, $CH_4$ anneal) instead of co-implantation.

A thermal treatment and metal deposition may then be performed (FIGS. 7B-7C). The thermal treatment moves upward non-semiconductor atoms (oxygen in the present example) from the non-semiconductor monolayers of the dopant diffusion blocking superlattices **125'** which react with the metal to form respective source and drain contact insulating interfaces **140', 141'** between the upper source and drain regions and adjacent portions of metal layers **142', 143'** formed by the metal deposition. Stated alternatively, as the oxygen atoms disassociate from the superlattice **125'** in the source and drain regions and move upward to form the contact insulating interfaces **140', 141'** so that there is no longer a defined superlattice layer separating the lower/upper source regions **104', 105'** and lower/upper drain regions **106', 107'** (see FIG. 7B).

In accordance with one example implementation, a $Co/Co_{0.75}Ti_{0.25}$ (2nm) metal deposition may be performed at a temperature in a range of about +200-400C for approximately 10 min. to form the source and drain contact insulating interfaces **140', 141'** and metal layers **142', 143'**. Moreover, in some implementations, an additional metal deposition (e.g., Co) may be performed to form upper source/drain metal contact layers **144', 145'** in the semiconductor device **100'**.

Another example embodiment similar to the semiconductor device **200** is now described with reference to FIG. 8. In this illustrated example, the source and drain dopant diffusion blocking superlattices **225s', 225d'** advantageously provide for Schottky barrier height modulation via hetero-epitaxial film integration. More particularly, the lower source and drain regions **204', 206'** include a different material than the upper source and drain regions **205', 207'**. In this example, the lower source and drain regions **204', 206'** are silicon, and the upper source and drain regions **205', 207'** are SiGeC, although different materials may be used in different embodiments.

Because the MST material is effective in integrating hetero-epitaxial semiconductor material, incorporation of C(1-2%) to Si or SiGe on Si may induce a positive conduction band offset. More particularly, this is a SiGeC/MST/n+ Si structure that is effective for reducing Schottky barrier height.

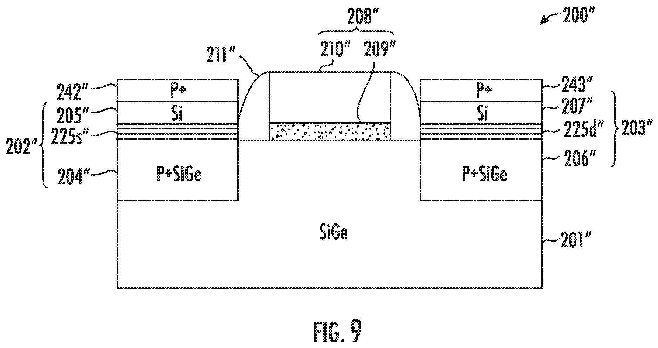

Referring additionally to FIG. 9, another similar semiconductor device **200"** advantageously provides for Schottky barrier height modulation via hetero-epitaxial film integration. In the illustrated example, the semiconductor layer/substrate **201"** is silicon germanium, and the lower source/drain regions **204", 206"** are P+ SiGe. Moreover, the upper source/drain regions **205", 207"** are also silicon, and a respective platinum contact layer **242", 243"** is formed on each of the upper source/drain regions. The upper source/drain regions **205", 207"** may be formed in a relatively thin epitaxial silicon layer (e.g., 2-5 nm). Here again, the MST material is effective in integrating hetero-epitaxial semiconductor material, and strained Si on SiGe (or Ge) may advantageously induce negative valence band offset. As a result, the illustrated s-Si/MST/p+ SiGe structure may be effective for reducing Schottky barrier height as well.

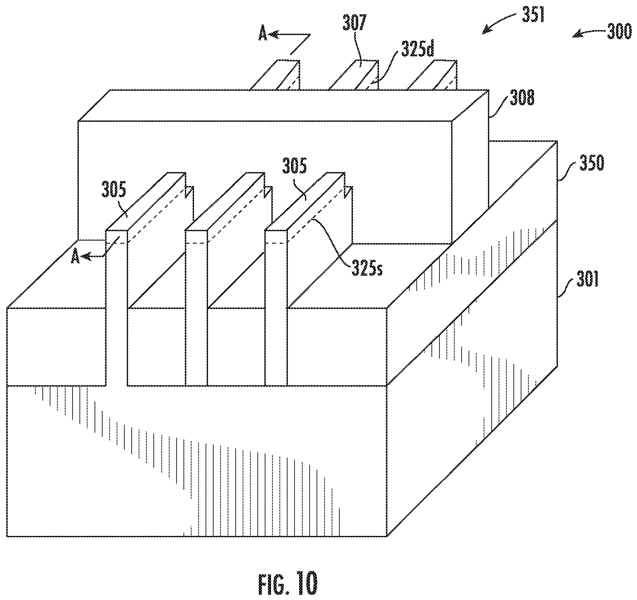

Turning now additionally to FIG. 10, certain of the above-described planar FET configurations may also advantageously be implemented in vertical semiconductor devices as well. An example FINFET **300** illustratively includes a semiconductor layer or substrate **301** (e.g., silicon), an insulating layer **350** on the substrate (e.g., $SiO_2$), and one or more semiconductor fins **351** extending vertically upward from the substrate through the insulating layer.

Spaced apart source and drain regions **302, 303** are formed in each semiconductor fin **351** with a channel region **330** extending therebetween. A source dopant diffusion blocking superlattice **325s** extends through the source region **302** to divide the source region into a lower source region **304** and an upper source region **305,** and a drain dopant diffusion blocking superlattice **325d** extends through the drain region **303** to divide the drain region into a lower drain region **306** and an upper drain region **307**. Similar to the embodiment of FIG. 6, the upper source/drain regions **305, 307** have a same conductivity and higher dopant concentration (N++) than the lower source/drain regions **304, 306** (N+). Moreover, the upper source/drain regions **305, 307** extend above an upper surface of the semiconductor fin **351**. That is, superlattices **325s, 325d** may be formed on the top of the semiconductor fin **351,** and the upper source/drain regions **305, 307** may be epitaxially grown on the respective superlattices. In this regard, the upper source/drain regions **305, 307** may implanted with a dopant, or they may be in-situ doped epitaxial layers as described above.

The FINFET **300** also illustratively includes a gate **308** overlying the channel regions **330** of the fins **351.** The gate **308** illustratively includes a gate insulator **309** and a gate electrode **310** on the gate insulator.

In accordance with another example implementation, a FINFET **300'** may be fabricated using a similar process to that described above with respect to FIGS. 7A-7C, i.e., involving a thermal treatment and metal deposition to define source/drain insulating layers **340', 341'** between the upper source/drain regions **305', 307'** and metal layers **342', 343'** (e.g., $CoTi_x$) respectively. Upper metal layers **344', 345'** (e.g., Co) may also be formed on the lower metal layers **342', 343'** in some embodiments. Here again, the heat treatment causes the non-semiconductor atoms in the source/drain dopant blocking superlattice layers to move upward, leaving no superlattice between the upper source/drain regions **305', 307'** and the lower source/drain regions **304', 306'** in the final FINFET **300'.** Here again, this approach advantageously provides for Schottky barrier height modulation by controlling the thickness and composition of the interfacial insulators **340', 341'**.

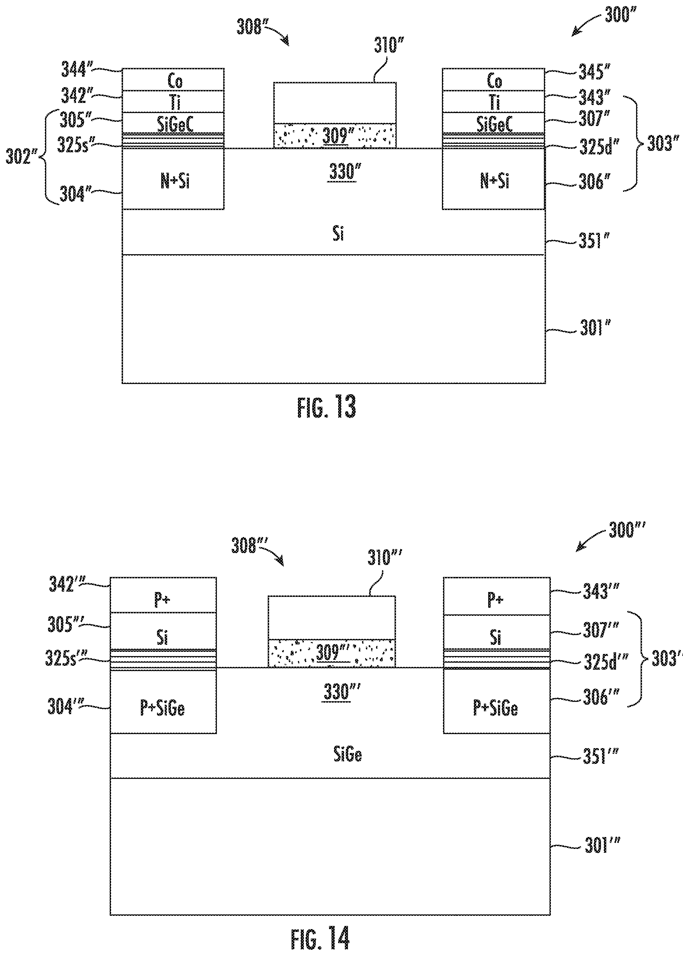

Referring additionally to FIG. 13, a FINFET **300"** is provided which is similar to embodiment of FIG. 8 above, in that the source and drain dopant blocking superlattices **325s", 325d"** advantageously provide for Schottky barrier height modulation via hetero-epitaxial film integration. More particularly, the lower source and drain regions **304", 306"** include a different material than the upper source and drain regions **305", 307".** In this example, the lower source and drain **304", 306"** regions are silicon, and the upper source and drain regions **305", 307"** are SiGeC, although different materials may be used in different embodiments. Also, the lower metal layers **342", 342"** are titanium, and the upper metal layers **344", 345"** are cobalt in the illustrated example.

In still another example shown in FIG. 14, similar to the embodiment of FIG. 9 the FINFET **300‴** may also provide for Schottky barrier height modulation via hetero-epitaxial film integration. In the illustrated example, the semiconductor fin **351'** is silicon germanium, and the lower source/drain regions **304", 306"** are P+ SiGe. Moreover, the upper source/drain regions **305", 307"** are silicon, and a respective platinum contact layer **342", 343"** is formed on each of the upper source/drain regions. Here again, the upper source/drain regions **305", 307"** may be formed in a relatively thin epitaxial silicon layer (e.g., 2-5 nm).

In the above-described examples, a dopant blocking superlattice is shown in both of the source and drain regions of the illustrated devices. However, it should be noted that in some embodiments both of the source and drain regions need not have a dopant blocking superlattice. That is, the dopant blocking superlattice may be in just one of the source or drain regions in some embodiments.

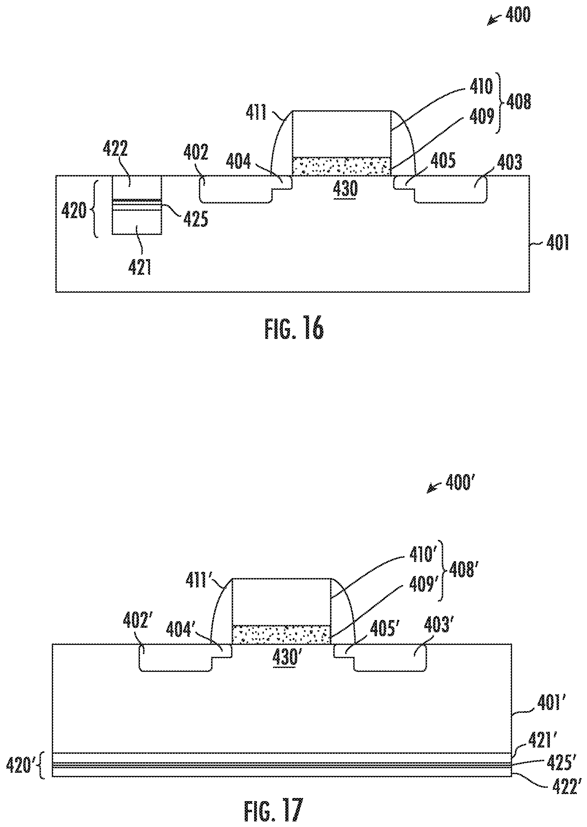

Furthermore, turning now to FIG. 16, a dopant blocking superlattice is incorporated in a body contact to provide reduced body contact resistance in addition to, or instead of, in the source/drain regions. A semiconductor device **400** (here a planar FET) includes a semiconductor layer or substrate **401,** spaced apart source and drain regions **402, 403** (which have respective lightly doped source/drain extensions **404, 405** in this example) in the semiconductor layer **401** with a channel region **430** extending therebetween, and a gate **408** on the channel region with sidewall spacers **411.** As similarly described above, the gate **408** illustratively includes a gate insulator **409** and a gate electrode **410.** The semiconductor device **400** further illustratively includes a body contact **420** in the semiconductor layer **401** and comprising a body contact dopant diffusion blocking superlattice **425** extending through the body contact to divide the body contact into a first body contact region **421** and a second body contact region **422.** As similarly described above, the second body contact region **422** has a same conductivity and higher dopant concentration than the first body contact region **421.** Here again, the body contact dopant diffusion blocking superlattice **425** may be similar to those superlattice structures described above, and the materials used for, and dopant concentrations within, the first and second body contact regions **421, 422** may also be similar to those described above to provide desired contact resistance reduction.

In another example device **400'** shown in FIG. 17, a similar configuration is provided which has a back-side body contact **420'** instead of the topside or front-side body contact **420** shown in FIG. 16. The remaining components are similar to those discussed with reference to FIG. 16 and accordingly require no further discussion herein. It should be noted that in the back-side implementation the first and second regions **421', 422'** are flipped vertically with respect to the first and second regions **421, 422** in the device **400,** as they are on the opposite side of the device **400'.**

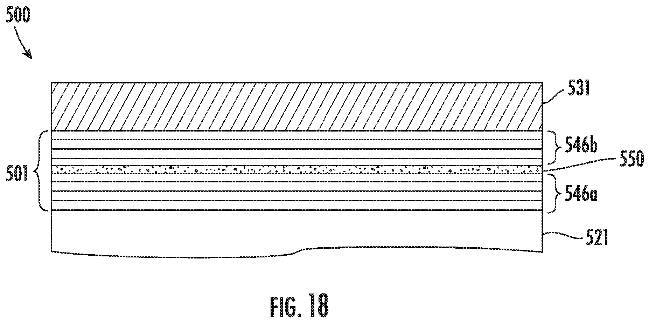

Turning now to FIG. 18, another example contact structure **500** is now described which may be also be used in certain implementations of source/drain, body, or other contacts to provide reduced Schottky barrier height and thereby decreased contact resistance. The contact **500** is formed in a semiconductor layer **501.** The contact illustratively includes one or more oxygen monolayers **550** constrained within a crystal lattice of adjacent semiconductor portions **546a, 546b** of the semiconductor layer **501.** The oxygen monolayer(s) **550** is and spaced apart from a surface of the semiconductor layer **501** by between one and four monolayers (a four monolayer spacing is shown in the semiconductor portion **546b** in the illustrated example). Furthermore, a metal layer **531** (which may include the same metals discussed above) is formed on the surface of the semiconductor layer **501** above the oxygen monolayer(s) **550.** The contact **500** may be formed on a semiconductor layer or substrate **521.**

By way of example, a dopant concentration within the portion **546b** (i.e., between the oxygen monolayer(s) **550** and the metal layer **531**) may be $1\times10^{21}$ atoms/cm$^3$ or greater (although lower concentrations may also be used in different embodiments). Considered alternatively, a dopant concentration equivalent to approximately 2% of the crystalline sites in a silicon lattice may advantageously be occupied by dopant atoms in an example configuration. This is based upon an estimate for the maximum distance range over which the oxygen monolayer can directly trap dopants (e.g., boron) sufficiently close to the metal to directly reduce the Schottky barrier of the contact, as opposed to reducing diffusion, yet while otherwise retaining a conventional doped metal-semiconductor interface with a bulk-line environment for the dopant atoms, and the minimum concentration of dopants where a benefit will be realized.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims. Any portions of the description that fall outside the scope of the appended claims are present for illustration purposes and may be useful for understanding the invention

**Claims**

1. A semiconductor device (400) comprising:

   a semiconductor layer (401);
   spaced apart source and drain regions (402, 403) in the semiconductor layer with a channel region (430) extending therebetween;
   a gate (408) on the channel region;
   a body contact (420) in the semiconductor layer and comprising a body contact dopant diffusion blocking superlattice (425) within the semiconductor layer (401) and extending through the body contact to divide the body contact into a first body contact region (421) and a second body contact region (422) with the second body contact region having a same conductivity and higher dopant concentration than the first body contact region; and
   a metal contact on the second body contact region;
   the body contact dopant diffusion blocking superlattice comprising a respective plurality of stacked groups of layers (45a-45n), each group of layers comprising a plurality of stacked base semiconductor monolayers (46) defining a base semiconductor portion (46a-46n), and at least one non-semiconductor monolayer (50) constrained within a crystal lattice of adjacent base semiconductor portions.

2. The semiconductor device of Claim 1 wherein the source and drain regions and the body contact are on a top side of the semiconductor layer.

3. The semiconductor device of Claim 1 wherein the source and drain regions (402', 403') are on a top side of the semiconductor layer (401'), and the body contact (420') is on a back side of the semiconductor layer opposite the top side.

4. The semiconductor device of Claim 1 wherein the second body contact region is level with a second surface of the semiconductor layer.

5. The semiconductor device of Claim 1 wherein the second body contact region is raised above a second surface of the semiconductor layer.

6. The semiconductor device of Claim 1 wherein the first body contact region comprises a different material than the second body contact region.

7. The semiconductor device of Claim 6 wherein the first body contact region comprises silicon; and wherein the second body contact region comprises silicon germanium.

8. The semiconductor device of Claim 6 wherein the first body contact region comprises silicon germanium; and wherein the second body contact region comprises silicon.

9. The semiconductor device of Claim 1 wherein the metal contact comprises at least one of titanium, cobalt, nickel and platinum.

10. The semiconductor device of Claim 1 wherein the base semiconductor monolayers comprise silicon.

11. The semiconductor device of Claim 1 wherein the at least one non-semiconductor monolayer comprises oxygen.

12. A method for making a semiconductor device (400) comprising:

   forming spaced apart source and drain regions (402, 403) in a semiconductor layer (401) with a channel region (430) extending therebetween;
   forming a gate (408) on the channel region;
   forming a body contact (420) in the semiconductor layer and comprising a body contact dopant diffusion blocking superlattice (425) within the semiconductor layer and extending through the body contact to divide the body contact into a first body contact region (421) and a second body contact region (422) with the second body contact region having a same conductivity and higher dopant concentration than the first body contact region; and
   forming a metal contact on the second body contact region;
   the body contact dopant diffusion blocking superlattice comprising a respective plurality of stacked groups of layers (45a-45n), each group of layers comprising a plurality of stacked base semiconductor monolayers (46) defining a base semiconductor portion (46a-46n), and at least one non-semiconductor monolayer (50) constrained within a crystal lattice of adjacent base semiconductor portions.

13. The method of Claim 12 wherein the source and drain regions and the body contact are on a top side of the semiconductor layer.

14. The method of Claim 12 wherein the source and drain regions (402', 403') are on a top side of the semiconductor layer (401'), and the body contact (420') is on a back side of the semiconductor layer opposite the top side.

**Patentansprüche**

1. Ein Halbleiterbauelement (400), umfassend:

   eine Halbleiterschicht (401);
   voneinander beabstandete Source- und Drain-Bereiche (402, 403) in der Halbleiterschicht mit einem Kanalbereich (430), der sich dazwischen erstreckt;
   ein Gate (408) auf dem Kanalbereich;
   einen Körperkontakt (420) in der Halbleiterschicht, umfassend ein Supergitter (425) zur Blockierung der Dotierungsdiffusion im Körperkontakt innerhalb der Halbleiterschicht (401) und sich durch den Körperkontakt erstreckend, um den Körperkontakt in einen ersten Körperkontaktbereich (421) und einen zweiten Körperkontaktbereich (422) zu unterteilen, wobei der zweite Körperkontaktbereich die gleiche Leitfähigkeit und eine höhere Dotierstoffkonzentration als der erste Körperkontaktbereich aufweist; und
   einen Metallkontakt auf dem zweiten Körperkontaktbereich;
   das Supergitter zur Blockierung der Dotierungsdiffusion im Körperkontakt umfasst eine jeweilige Vielzahl von gestapelten Gruppen von Schichten (45a-45n), wobei jede Gruppe von Schichten eine Vielzahl von gestapelten Basishalbleitermonolagen (46) umfasst, die einen Basishalbleiterabschnitt (46a-46n) definieren, und mindestens eine Nicht-Halbleitermonolage (50), die innerhalb eines Kristallgitters benachbarter Basishalbleiterabschnitte eingeschränkt ist.

2. Das Halbleiterbauelement nach Anspruch 1, wobei die Source- und Drain-Bereiche und der Körperkontakt auf einer Oberseite der Halbleiterschicht angeordnet sind.

3. Das Halbleiterbauelement nach Anspruch 1, wobei die Source- und Drain-Bereiche (402', 403') auf einer Oberseite der Halbleiterschicht (401') angeordnet sind und der Körperkontakt (420') auf einer Rückseite der Halbleiterschicht gegenüber der Oberseite angeordnet ist.

4. Das Halbleiterbauelement nach Anspruch 1, wobei der zweite Körperkontaktbereich auf einer zweiten Oberfläche der Halbleiterschicht liegt.

5. Das Halbleiterbauelement nach Anspruch 1, wobei der zweite Körperkontaktbereich über einer zweiten Oberfläche der Halbleiterschicht erhöht ist.

6. Das Halbleiterbauelement nach Anspruch 1, wobei der erste Körperkontaktbereich ein anderes Material als der zweite Körperkontaktbereich umfasst.

7. Das Halbleiterbauelement nach Anspruch 6, wobei der erste Körperkontaktbereich Silizium umfasst und der zweite Körperkontaktbereich Silizium-Germanium umfasst.

8. Das Halbleiterbauelement nach Anspruch 6, wobei der erste Körperkontaktbereich Silizium-Germanium umfasst und der zweite Körperkontaktbereich Silizium umfasst.

9. Das Halbleiterbauelement nach Anspruch 1, wobei der Metallkontakt mindestens eines von Titan, Kobalt, Nickel und Platin umfasst.

10. Das Halbleiterbauelement nach Anspruch 1, wobei die Basishalbleitermonolagen Silizium umfassen.

**11.** Das Halbleiterbauelement nach Anspruch 1, wobei die mindestens eine Nicht-Halbleitermonolage Sauerstoff umfasst.

**12.** Ein Verfahren zur Herstellung eines Halbleiterbauelements (400), umfassend:

Bilden voneinander beabstandeter Source- und Drain-Bereiche (402, 403) in einer Halbleiterschicht (401) mit einem Kanalbereich (430), der sich dazwischen erstreckt;
Bilden eines Gates (408) auf dem Kanalbereich;
Bilden eines Körperkontakts (420) in der Halbleiterschicht, umfassend ein Supergitter (425) zur Blockierung der Dotierungsdiffusion im Körperkontakt innerhalb der Halbleiterschicht und sich durch den Körperkontakt erstreckend, um den Körperkontakt in einen ersten Körperkontaktbereich (421) und einen zweiten Körperkontaktbereich (422) zu unterteilen, wobei der zweite Körperkontaktbereich die gleiche Leitfähigkeit und eine höhere Dotierstoffkonzentration als der erste Körperkontaktbereich aufweist; und
Bilden eines Metallkontakts auf dem zweiten Körperkontaktbereich;
das Supergitter zur Blockierung der Dotierungsdiffusion im Körperkontakt umfasst eine jeweilige Vielzahl von gestapelten Gruppen von Schichten (45a-45n), wobei jede Gruppe von Schichten eine Vielzahl von gestapelten Basishalbleitermonolagen (46) umfasst, die einen Basishalbleiterabschnitt (46a-46n) definieren, und mindestens eine Nicht-Halbleitermonolage (50), die innerhalb eines Kristallgitters benachbarter Basishalbleiterabschnitte eingeschränkt ist.

**13.** Das Verfahren nach Anspruch 12, wobei die Source- und Drain-Bereiche und der Körperkontakt auf einer Oberseite der Halbleiterschicht angeordnet sind.

**14.** Das Verfahren nach Anspruch 12, wobei die Source- und Drain-Bereiche (402', 403') auf einer Oberseite der Halbleiterschicht (401') angeordnet sind und der Körperkontakt (420') auf einer Rückseite der Halbleiterschicht gegenüber der Oberseite angeordnet ist.

**Revendications**

**1.** Dispositif semi-conducteur (400), comprenant :

une couche semi-conductrice (401) ;
des régions de source et de drain espacées entre elles (402, 403) dans la couche semi-conductrice avec une région de canal (430) s'étendant entre elles ;
une grille (408) sur la région de canal ;
un contact de corps (420) dans la couche semi-conductrice et qui comprend un super-réseau de blocage de diffusion de dopant de contact de corps (425) à l'intérieur de la couche semi-conductrice (401) et qui s'étend à travers le contact de corps afin de diviser le contact de corps en une première région de contact de corps (421) et une deuxième région de contact de corps (422), la deuxième région de contact de corps ayant une même conductivité et une concentration de dopant plus élevée que la première région de contact de corps ; et
un contact métallique sur la deuxième région de contact de corps,
le super-réseau de blocage de diffusion de dopant de contact de corps comprenant une pluralité respective d'empilements de groupes de couches (45a-45n), chaque groupe de couches comprenant une pluralité d'empilements de monocouches semi-conductrices de base (46) définissant une portion semi-conductrice de base (46a-46n), et au moins une monocouche non semi-conductrice (50) contrainte dans un réseau cristallin de portions semi-conductrices de base adjacentes.

**2.** Dispositif semi-conducteur selon la revendication 1, dans lequel les régions de source et de drain et le contact de corps se trouvent sur une face supérieure de la couche semi-conductrice.

**3.** Dispositif semi-conducteur selon la revendication 1, dans lequel les régions de source et de drain (402', 403') se trouvent sur une face supérieure de la couche semi-conductrice (401'), et le contact de corps (420') se trouve sur une face arrière de la couche semi-conductrice à l'opposé de la face supérieure.

**4.** Dispositif semi-conducteur selon la revendication 1, dans lequel la deuxième région de contact de corps est au niveau d'une deuxième surface de la couche semi-conductrice.

**5.** Dispositif semi-conducteur selon la revendication 1, dans lequel la deuxième région de contact de corps est surélevée au-dessus d'une deuxième surface de la couche semi-conductrice.

**6.** Dispositif semi-conducteur selon la revendication 1, dans lequel la première région de contact de corps comprend un matériau différent de celui de la deuxième région de contact de corps.

**7.** Dispositif semi-conducteur selon la revendication 6, dans lequel la première région de contact de corps est constituée de silicium, et dans lequel la deuxième région de contact de corps est constituée de silicium-germanium.

**8.** Dispositif semi-conducteur selon la revendication 6, dans lequel la première région de contact de corps est constituée de silicium-germanium, et dans lequel la deuxième région de contact de corps est constituée de silicium.

**9.** Dispositif semi-conducteur selon la revendication 1, dans lequel le contact métallique est constitué d'au moins l'un des éléments suivants : titane, cobalt, nickel et platine.

**10.** Dispositif semi-conducteur selon la revendication 1, dans lequel les monocouches semi-conductrices de base sont constituées de silicium.

**11.** Dispositif semi-conducteur selon la revendication 1, dans lequel ladite au moins une monocouche non semi-conductrice est constituée d'oxygène.

**12.** Procédé de fabrication d'un dispositif semi-conducteur (400), consistant à :

former des régions de source et de drain espacées l'une de l'autre (402, 403) dans une couche semi-conductrice (401) avec une région de canal (430) s'étendant entre elles ;
former une grille (408) sur la région de canal ;
former un contact de corps (420) dans la couche semi-conductrice et qui comprend un super-réseau de blocage de diffusion de dopant de contact de corps (425) à l'intérieur de la couche semi-conductrice (401) et qui s'étend à travers le contact de corps afin de diviser le contact de corps en une première région de contact de corps (421) et une deuxième région de contact de corps (422), la deuxième région de contact de corps ayant une même conductivité et une concentration de dopant plus élevée que la première région de contact de corps ; et
former un contact métallique sur la deuxième région de contact de corps,
le super-réseau de blocage de diffusion de dopant de contact de corps comprenant une pluralité respective d'empilements de groupes de couches (45a-45n), chaque groupe de couches comprenant une pluralité d'empilements de monocouches semi-conductrices de base (46) définissant une portion semi-conductrice de base (46a-46n), et au moins une monocouche non semi-conductrice (50) contrainte dans un réseau cristallin de portions semi-conductrices de base adjacentes.

**13.** Procédé selon la revendication 12, dans lequel les régions de source et de drain et le contact de corps se trouvent sur une face supérieure de la couche semi-conductrice.

**14.** Procédé selon la revendication 12, dans lequel les régions de source et de drain (402', 403') se trouvent sur une face supérieure de la couche semi-conductrice (401'), et le contact de corps (420') se trouve sur une face arrière de la couche semi-conductrice à l'opposé de la face supérieure.

FIG. 1

FIG. 2

FIG. 3

FIG. 4A

FIG. 4B

FIG. 4C

FIG. 5

FIG. 6

DOPANT IMPLANTATION+
CO-IMPLANT (N,C,F)

111'

108'
110' 109'

DOPANT IMPLANTATION+
CO-IMPLANT (N,C,F)

102' { 105'

N++

130'

N++

107' } 103'
125'

104'

N+

N+

106'

101'

FIG. 7A

THERMAL TREATMENT

111'

108'
110' 109'

THERMAL TREATMENT

102' { 105'

N++

130'

N++

107' } 103'
106'

104'

N+

N+

125'

101'

FIG. 7B

FIG. 7C

FIG. 8

FIG. 9

FIG. 10

FIG. 11

FIG. 12

FIG. 13

FIG. 14

500

FIG. 15

FIG. 16

FIG. 17

FIG. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20030057416 A, Currie
- US 20030034529 A, Fitzgerald
- US 6472685 B2, Takagi
- US 4937204 A, Ishibashi
- US 5357119 A, Wang
- US 5683934 A, Candelaria
- US 5216262 A, Tsu
- US 7105895 B, Wang
- GB 2347520 A, Mears
- US 6376337 B, Wang
- US 20050279991 A1
- US 20110227191 A1

### Non-patent literature cited in the description

- **TSU**. Phenomena in silicon nanostructure devices. *Applied Physics and Materials Science & Processing*, 06 September 2000, 391-402
- **LUO et al.** Chemical Design of Direct-Gap Light-Emitting Silicon. *Physical Review Letters*, 12 August 2002, vol. 89 (7)